# EUROPÄISCHE PATENTSCHRIFT

(11) **EP 1 097 458 B1**
(45) Veröffentlichungstag und Bekanntmachung des Hinweises auf die Patenterteilung: **03.09.2003**
(21) Anmeldenummer: 99924695.2
(22) Anmeldetag: 25.03.1999
(51) Int. Cl.: G11C 11/22

(54) **SPEICHERANORDNUNG AUS EINER VIELZAHL VON RESISTIVEN FERROELEKTRISCHEN SPEICHERZELLEN**
STORAGE ASSEMBLY CONSISTING OF RESISTIVE FERROELECTRIC STORAGE CELLS
ENSEMBLE MEMOIRE CONSTITUE D'UNE PLURALITE DE CELLULES DE MEMOIRE FERROELECTRIQUES RESISTIVES

(30) Priorität: 22.07.1998 DE 19832995
(43) Veröffentlichungstag der Anmeldung: 09.05.2001
(73) Patentinhaber: Infineon Technologies AG, 81669 München (DE)
(72) Erfinder: KOWARIK, Oskar, D-85579 Neubiberg (DE); HOFFMANN, Kurt, D-82024 Taufkirchen (DE)
(74) Vertreter: Kottmann, Heinz Dieter, Dipl.-Ing.
(86) Internationale Anmeldenummer: DE9900920
(87) Internationale Veröffentlichungsnummer: WO00005721

(56) Entgegenhaltungen:
- WO-A-99/14761
- US-A- 4 712 876
- US-A- 5 898 609
- PATENT ABSTRACTS OF JAPAN vol. 096, no. 011, 29. November 1996 (1996-11-29) & JP 08 180671 A (MATSUSHITA ELECTRIC IND CO LTD), 12. Juli 1996 (1996-07-12)

## Beschreibung

Die vorliegende Erfindung betrifft eine Speicheranordnung aus einer Vielzahl von resistiven ferroelektrischen Speicherzellen aus jeweils einem Auswahltransistor und einem Speicherkondensator, dessen eine Elektrode auf einer festen Zellplattenspannung liegt und dessen andere Elektrode mit einer einen ersten Leitungstyp aufweisenden ersten Zone des Auswahltransistors verbunden ist, wobei der Auswahltransistor und der Speicherkondensator in bzw. auf einem Halbleitersubstrat eines zweiten, zum ersten Leitungstyp entgegengesetzten Leitungstyps vorgesehen und die einen Elektroden einer Mehrzahl von Speicherkondensatoren miteinander verbunden sind und die andere Elektrode des Speicherkondensators über einen Widerstand mit einer mit der Zellplattenspannung beaufschlagten Leitung, die durch eine hochdotierte Zone des ersten Leitungstyps gebildet ist, verbunden ist.

Ferroelektrische Speicheranordnungen, bei denen die Zellplattenspannung fest auf die halbe Versorgungsspannung (VCC/2) der Speicheranordnung gelegt ist, zeichnen sich durch schnelle Speicheroperationen aus. Allerdings tritt bei diesen Speicheranordnungen das Problem eines möglichen Verlustes der in den Speicherkondensatoren gespeicherten Daten auf: da die Zellknoten an den Speicherkondensatoren floatend sind, solange die Auswahltransistoren sperren, und diese Zellknoten parasitäre pn-Übergänge zum Halbleitersubstrat bilden, verursachen zwangsläufig auftretende Leckströme über diese pn-Übergänge ein Absinken der Zellknotenspannung auf Massespannung Vss. Die anderen Knoten der ferroelektrischen Speicherkondensatoren bleiben dabei auf der festen Zellplattenspannung Vcc/2 liegen. Dadurch kann der Inhalt der ferroelektrischen Speicherkondensatoren durch Umprogrammieren zerstört werden.

Um diesen Datenverlust zu vermeiden, wird ähnlich wie bei DRAMs ein Refresh der Speicherzellen vorgenommen, bevor deren Inhalt zerstört ist. Der Refresh erfolgt dadurch, dass die Bitleitungen der Speicheranordnung auf die halbe Versorgungsspannung Vcc/2 vorgeladen und die Zellknoten durch Aktivierung der Wortleitungen ebenfalls auf die halbe Versorgungsspannung Vcc/2 aufgeladen werden, so dass über den Speicherkondensatoren 0 V abfallen.

Ein solcher Refresh ist aufwändig und erfordert zusätzliche Operationen, die möglichst vermieden werden sollten.

Aus der Druckschrift WO 99 14761, auf der der Oberbegriff des Anspruchs 1 beruht, ist die Realisierung einer Widerstandseinrichtung parallel einer ferroelektrischen Kapazität einer Speicherzelle in der Form eines Widerstandes bekannt, der eine zweite Elektrode und eine "plate line" verbindet. Die "plate line" bezeichnet dabei eine Leitung, die erste Elektroden einer Mehrzahl einander auf einer Halbleitereinrichtung benachbarter ferroelektrischer Kapazitäten verbindet. Weiterhin ist in dieser Druckschrift ein erster Anschluss einer als Transistor ausgeführten Widerstandseinrichtung direkt anschließend an eine zweite Elektrode der ferroelektrischen Kapazität angeordnet. Ein zweiter Anschluss dieser Widerstandseinrichtung wird über eine Durchkontaktierung zu einer "common plate line" geführt. Dabei ist für jede Speicherzelle eine solche Durchkontaktierung vorgesehen. Schließlich ist aus dieser Druckschrift WO 99 14761 auch eine Realisierung einer Widerstandseinrichtung als eine zwischen zwei Widerstandswerten schaltbare Transistorstrecke bekannt. Dabei wird ein Transistor als Schalter vorgesehen, der über eine an einer "shunt line" angeschlossene Elektrode abhängig vom Betriebszustand der Speicherzelle zwischen den Zuständen "leitend" und "gesperrt" geschaltet werden kann. Der Schalter ist während eines Schreib- oder Lesevorgangs gesperrt und im Übrigen leitend.

Es ist Aufgabe der vorliegenden Erfindung, eine Speicheranordnung aus einer Vielzahl von resistiven ferroelektrischen Speicherzellen zu schaffen, die so gestaltet ist, dass ein Leckstrom am Zellknoten nicht mehr ein Umprogrammieren der Speicherzelle verursachen kann, so dass auf einen Refresh der Speicherzelle verzichtet werden kann, und die sich durch einen einfachen Aufbau der Speicherzellen auszeichnet.

Diese Aufgabe wird bei einer Speicheranordnung aus einer Vielzahl von resistiven ferroelektrischen Speicherzellen der eingangs genannten Art erfindungsgemäß dadurch gelöst, dass der Widerstand durch eine Dotierungsschicht unter einer Isolierschicht im Halbleiterkörper realisiert ist.

Der Widerstand wird dabei so beschaffen, dass sein Widerstandswert wesentlich kleiner als der Widerstandswert des Sperrwiderstandes des pn-Überganges zwischen der ersten Zone des Auswahltransistors und dem Halbleitersubstrat ist, und dass weiterhin der Lese- und Schreibvorgang durch diesen Widerstand nur äußerst geringfügig beeinflusst wird.

Dadurch wird sichergestellt, dass bei der erfindungsgemäßen Speicheranordnung der Lese- und Schreibvorgang durch den Widerstand nahezu ungestört ist und dennoch der Leckstrom des parasitären pn-Überganges zum Halbleitersubstrat durch diesen Widerstand kompensiert wird und an beiden Seiten des ferroelektrischen Speicherkondensators annähernd die Zellplattenspannung anliegt. Eine ungewollte Umprogrammierung des Speicherkondensators kann damit nicht mehr erfolgen.

Das von der erste Zone des Auswahltransistors abgewandte Ende des Widerstandes ist mit der mit der Zellplattenspannung beaufschlagten Leitung verbunden. Diese Leitung ist durch eine hochdotierte Zone des ersten Leitungstyps im Oberflächenbereich des Halbleiterkörpers gebildet.

Für die Realisierung des Widerstandes gibt es an sich verschiedene Möglichkeiten:

Erfindungsgemäß ist der Widerstand durch eine geeignete Dotierung unterhalb der Isolierschicht, dem so genannten Dickoxid, im Halbleiterkörper im Bereich zwischen der ersten Zone des Auswahltransistors und der aus einer hochdotierten Zone des ersten Leitungstyps gebildeten, mit der Zellplattenspannung beaufschlagten Leitung vorgesehen.

Es ist aber auch möglich, was nicht Gegenstand der Erfindung ist, für den Widerstand einen MOS-Transistor einzusetzen, an dessen Gate eine Referenzspannung derart anliegt, dass sich über dem Kanal des MOS-Transistors der Widerstand mit den gewünschten Eigenschaften, beispielsweise im Unterschwellstrombereich einstellt. Zusätzlich zu einer konstanten Gatespannung am Gate des MOS-Transistors kann nach jedem Lese- und Schreibvorgang sowie beim Anlegen und Abschalten der Versorgungsspannung an der Speicheranordnung diese Gatespannung auf einen Wert gebracht werden, so dass die einzelnen Elektroden der Speicherkondensatoren, die so genannten Kapazitätsknoten, in den Speicherzellen schnell auf die Zellplattenspannung gezogen werden. An einem derartigen Vorgehen ist vorteilhaft, dass die Kapazitätsknoten sofort nach der jeweiligen Operation auf die Zellplattenspannung gebracht werden. Es können hierbei alle Auswahltransistoren, beispielsweise beim Einund Ausschalten der Speicheranordnung, oder aber auch nur der zur jeweiligen Wortleitung und Bitleitung gehörige Auswahltransistor mit dem Wort- oder Bitleitungsdecodierer über die am Gate des MOS-Transistors anliegende Spannung ausgewählt werden.

Bei der erfindungsgemäßen Speicheranordnung ist ein unbeabsichtigtes Umprogrammieren durch den Leckstrom des parasitären pn-Überganges zum Halbleitersubstrat sowie beim Ein- und Ausschalten der Speicheranordnung nicht möglich. In gleicher Weise kann auch beim Abschalten der Versorgungsspannung ein unbeabsichtigtes Umprogrammieren nicht erfolgen. Außerdem ist die erfindungsgemäße Speicheranordnung sehr einfach aufgebaut. Insbesondere kann bei ihr ein normaler Wortleitungsdecodierer eingesetzt werden. Auch ist die Kapazität der Wortleitung nicht vergrößert. Zwischen dem Widerstand, der durch eine Dotierungsschicht unter einer Isolierschicht im Halbleiterkörper realisiert ist, und der mit der festen Zellplattenspannung beaufschlagten Elektrode des Speicherkondensators ist kein Plug bzw. Stöpsel erforderlich, was geringere Anforderungen an die Herstellungsschritte bedeutet und weniger Platz erforderlich macht, da für den Plug kein gesondertes Kontaktloch benötigt wird. Das heißt, die Speicherzellen der erfindungsgemäßen Speicheranordnung benötigen nicht mehr Platz als die Zellfläche einer Standard-Speicherzelle.

Nachfolgend wird die Erfindung anhand der Zeichnungen näher erläutert. Es zeigen:
- Fig. 1: ein Schaltbild eines Speicherzellenfeldes aus der erfindungsgemäßen Speicheranordnung,
- Fig. 2: eine schematische Schnittdarstellung der Speicheranordnung nach einem Ausführungsbeispiel der Erfindung,
- Fig. 3: eine schematische Draufsicht auf die Speicheranordnung gemäß Fig. 2,
- Fig. 4: eine schematische Schnittdarstellung einer Speicheranordnung, welche das Verständnis der Erfindung erleichtert,
- Fig. 5: eine schematische Draufsicht auf die Speicheranordnung nach Fig. 4
- Fig. 6: eine schematische Schnittdarstellung durch eine Abwandlung der Speicheranordnung nach Fig. 4 und
- Fig. 7: eine schematische Draufsicht auf die Speicheranordnung von Fig. 6

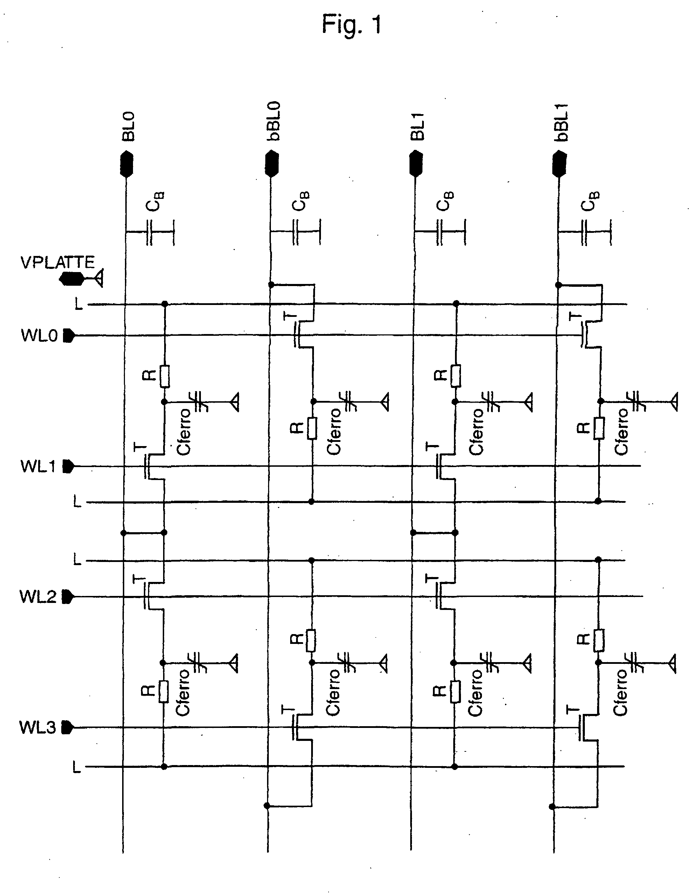

Fig. 1 zeigt ein Speicherzellenfeld in gefalteter Bitleitungstungsarchitektur mit Wortleitung WL0, WL1, WL2 und WL3 und Kapazitäten C_{B} aufweisenden Bitleitungen BL0, bBL0, BL1 und bBL1 für Eintransistor-Einkondensator-(1T1C-)Speicherzellen aus Auswahltransistoren T und ferroelektrischen Speicherkondensatoren Cferro.

An den einen Elektroden der Speicherkondensatoren Cferro liegt eine feste Zellplattenspannung, die erfindungsgemäß jeweils über einen Widerstand R und eine Leitung L aus beispielsweise einer hochdotierten Zone des ersten Leitungstyps im Halbleiterkörper gebildet ist. Diese hochdotierte Zone kann insbesondere eine n⁺-leitende streifenförmige Zone sein.

Der Widerstand R, der zwischen den Speicherkondensatoren Cferro und der Leitung L liegt, die mit der Zellplattenspannung VPLATTE beaufschlagt ist, muss so beschaffen sein, dass
(a) der Widerstandswert dieses Widerstandes R wesentlich kleiner als der Widerstandswert des Sperrwiderstandes des pn-Überganges zwischen der ersten Zone des Auswahltransistors und dem Halbleitersubstrat ist, und
(b) der Lese- und Schreibvorgang durch den Widerstand R nur äußerst geringfügig beeinflusst wird.

Werden diese Bedingungen für den Widerstand R eingehalten, so ist sichergestellt, dass der Lese- und Schreibvorgang in den einzelnen Speicherzellen durch den Widerstand R nahezu ungestört bleibt und der Leckstrom des parasitären pn-Überganges zum Halbleitersubstrat durch den durch den Widerstand R fließenden Strom kompensiert wird. Dadurch liegt an beiden Seiten der ferroelektrischen Speicherkondensatoren, also an den beiden Kapazitätsknoten, annähernd die Zellplattenspannung an. Eine ungewollte Umprogrammierung der Speicherkondensatoren kann dann nicht mehr erfolgen.

Der zu dem ferroelektrischen Speicherkondensator Cferro entgegengesetzte Anschluss des Widerstandes R wird mit der Leitung L auf der Zellplattenspannung VPLATTE gehalten, so dass am ferroelektrischen Speicherkondensator Cferro bei Abschalten des Auswahltransistors T nahezu die gleiche Spannung anliegt, wodurch eine Umprogrammierung des ferroelektrischen Speicherkondensators Cferro ausgeschlossen ist.

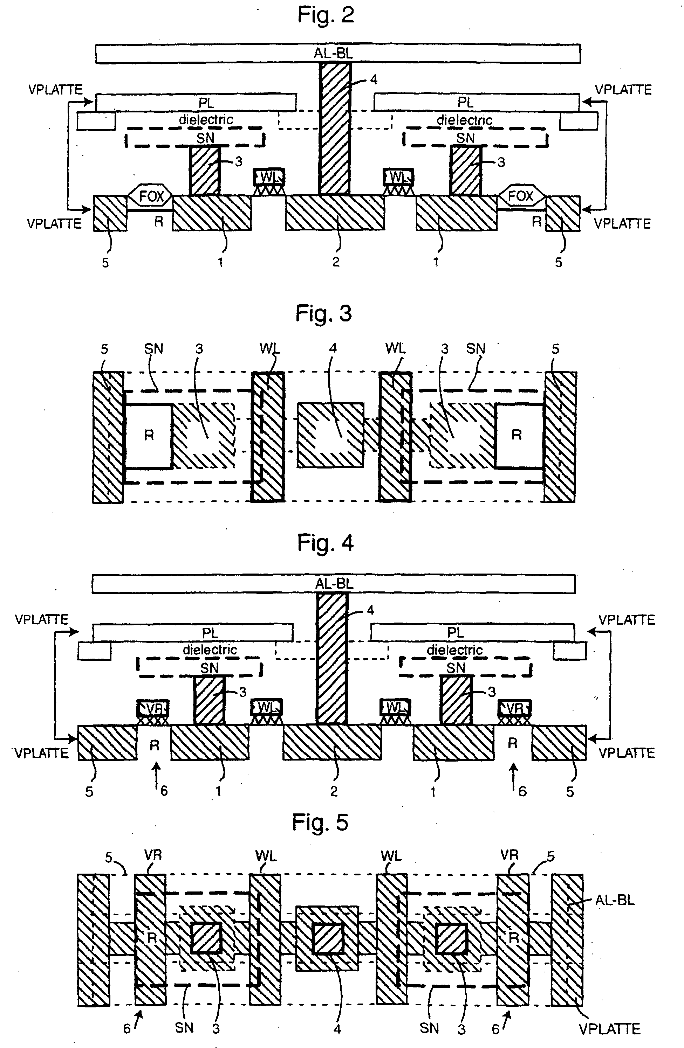

Für die Realisierung des Widerstandes R gibt es an sich verschiedene Möglichkeiten, die im folgenden anhand der Fig. 2 bis 7 näher erläutert werden sollen. Grundsätzlich besteht die Möglichkeit, den Widerstand R erfindungsgemäß durch eine geeignete Dotierung unter der Isolierschicht neben dem Auswahltransistor auszubilden (vgl. Fig. 2 und 3) oder aber für diesen Widerstand einen MOS-Transistor vorzusehen, der über seine Gatespannung VR so eingestellt wird, dass sich über dem Kanal dieses MOS-Transistors ein Widerstand mit den gewünschten Eigenschaften einstellt (vgl. Fig. 4 bis 7).

Fig. 2 zeigt n⁺-leitende Drainzonen 1 und eine n⁺-leitende Sourcezone 2 im Oberflächenbereich eines nicht näher bezeichneten p-leitenden Halbleiterkörpers, wobei oberhalb des Kanalbereiches zwischen der Drainzone 1 und der Sourcezone 2 eine Wortleitung WL vorgesehen ist. Diese Wortleitung WL ist in eine Isolierschicht aus beispielsweise Siliziumdioxid und/oder Siliziumnitrid eingebettet. Die Drainzone 1 ist über eine Plug 3 aus beispielsweise polykristallinem Silizium mit einer Elektrode SN eines ferroelektrischen Speicherkondensators verbunden, dessen Dielektrikum dielectric die Elektrode SN von einer gemeinsamen Elektrode PL trennt, an der die Zellplattenspannung VPLATTE anliegt. Die einzelnen Elektroden PL stehen miteinander in Verbindung, wie dies durch Strichlinien in der Fig. 2 angedeutet ist.

Die Sourcezone 2 ist über eine Plug bzw. Stöpsel 4 mit einer vorzugsweise aus Aluminium bestehenden Bitleitung AL-BL verbunden. Dieser Plug 4 ist selbstverständlich von den Elektroden PL elektrisch getrennt.

Der Widerstand R wird erfindungsgemäß durch eine geeignete Dotierung unterhalb der Isolierschicht bzw. eines Dickoxides FOX zwischen der Drainzone 1 und einer hochdotierten, n⁺leitenden Zone 5 gebildet, über die die Zellplattenspannung VPLATTE zu dem der Drainzone 1 gegenüberliegenden Anschluss des Widerstandes R zugeführt wird.

Geeignete Dotierungskonzentrationen für den Widerstand R liegen in der Größenordnung der Substratdotierung. Um den Widerstand gegenüber dem Substratwiderstand zu erhöhen, liegt die Dotierungskonzentration darunter, um ihn zu reduzieren, liegt die Dotierungskonzentration über der der Substratdotierung.

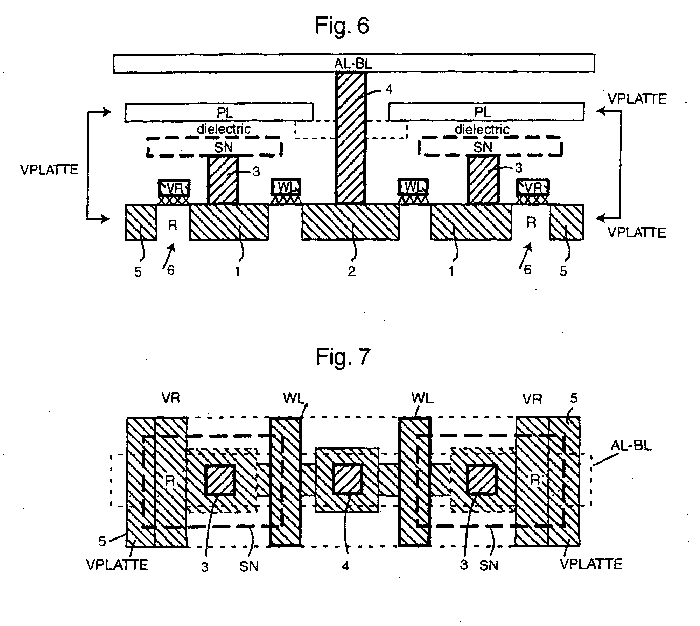

Die Fig. 4 und 5 zeigen eine Speicheranordnung, die nicht zur Erfindung gehört, während in den Fig. 6 und 7 eine Abwandlung dieser Speicheranordnung dargestellt ist. In den Fig. 4 bis 7 werden dabei für einander entsprechende Bauteile die gleichen Bezugszeichen wie in den Fig. 2 und 3 verwendet.

Bei der Speicheranordnung der Fig. 4 und 5 wird der Widerstand R durch eine MOS-Transistor 6 realisiert, an dessen Gate 7 eine Gatespannung VR anliegt, die so eingestellt wird, dass sich über dem Kanal des MOS-Widerstandes 6 der Widerstand R mit den gewünschten Eigenschaften einstellt.

Die Fig. 6 und 7 zeigen eine Abwandlung der Speicheranordnung der Fig. 4 und 5. Hier ist der Widerstand R ebenfalls durch den MOS-Transistor 6 realisiert, dem eine geeignete Gatespannung VR zugeführt wird, während die Zellplattenspannung VPLATTE über die n⁺-leitende, hochdotierte Zone 5 angelegt wird. Im Unterschied zu der Variante der Fig. 4 und 5 ist hier ein so genanntes "aggressives Layout" angewandt, das eine besonders kompakte Gestaltung der Speicheranordnung erlaubt und hierfür keine zusätzlichen Prozessschritte benötigt.

## Patentansprüche

1. Speicheranordnung aus einer Vielzahl von resistiven ferroelektrischen Speicherzellen aus jeweils einem Auswahltransistor (T) und einem Speicherkondensator (Cferro), dessen eine Elektrode (PL) auf einer festen Zellplattenspannung (VPLATTE) liegt und dessen andere Elektrode (SN) mit einer einen ersten Leitungstyp aufweisenden ersten Zone (1) des Auswahltransistors verbunden ist, wobei
- der Auswahltransistor (T) und der Speicherkondensator (Cferro) in bzw. auf einem Halbleiterkörper eines zweiten, zum ersten Leitungstyp entgegengesetzten Leitungstyps vorgesehen und die einen Elektroden (PL) einer Mehrzahl von Speicherkondensatoren (Cferro) miteinander verbunden sind, und
- die andere Elektrode (SN) des Speicherkondensators (Cferro) über einen Widerstand (R) mit einer mit der Zellplattenspannung (VPLATTE) beaufschlagten Leitung (5), die durch eine hochdotierte Zone des ersten Leitungstyps gebildet ist, verbunden ist,
**dadurch gekennzeichnet, dass**
- der Widerstand (R) durch eine Dotierungsschicht unter einer Isolierschicht (FOX) im Halbleiterkörper realisiert ist.

2. Speicheranordnung nach Anspruch 1,
**dadurch gekennzeichnet, dass**
der Widerstandswert des Widerstandes (R) wesentlich kleiner als der Widerstandswert des Sperrwiderstandes des pn-Überganges zwischen der ersten Zone (1) des Auswahltransistors (T) und dem Halbleitersubstrat ist.

3. Speieheranordnung nach Anspruch 1 oder 2,
**dadurch gekennzeichnet, dass**
der Widerstandswert des Widerstandes (R) derart eingestellt ist, dass Lese- und Schreibvorgänge aus bzw. in die Speicheranordnung durch den Widerstand (R) praktisch nicht beeinflusst sind.

## Claims

1. Memory arrangement comprising a multiplicity of resistive ferroelectric memory cells each comprising a selection transistor (T) and a storage capacitor (Cferro), one electrode (PL) of which is at a fixed cell plate voltage (VPLATE) and the other electrode (SN) of which is connected to a first zone (1) of the selection transistor, the said zone having a first conduction type,
- the selection transistor (T) and the storage capacitor (Cferro) respectively being provided in and on a semiconductor body of a second conduction type, which is opposite to the first conduction type, and the first electrode (PL) of a plurality of storage capacitors (Cferro) being connected to one another, and
- the other electrode (SN) of the storage capacitor (Cferro) being connected via a resistor (R) to a line (5) formed by a highly doped zone of the first conduction type, to which line the cell plate voltage (VPLATE) is applied,
**characterized in that**
- the resistor (R) is realized by a doping layer below an insulating layer (FOX) in the semiconductor body.

2. Memory arrangement according to Claim 1,
**characterized in that**
the resistance value of the resistor (R) is significantly lower than the resistance value of the reverse resistance of the pn junction between the first zone (1) of the selection transistor (T) and the semiconductor substrate.

3. Memory arrangement according to Claim 1 or 2,
**characterized in that**
the resistance value of the resistor (R) is set in such a way that operations of reading and writing from and respectively to the memory arrangement are practically not influenced by the resistor (R).

## Revendications

1. Dispositif de mémoire constitué d'une pluralité de cellules de mémoire ferroélectriques résistives comportant chacune un transistor (T) de sélection et un condensateur (Cferro) de mémoire, dont une électrode (PL) est à une tension (VPLATTE) fixe de plaque de cellule et dont l'autre électrode (SN) est reliée à une première zone (1) ayant un premier type de conductivité du transistor de sélection, dans lequel
- le transistor (T) de sélection et le condensateur (Cferro) de mémoire sont prévus dans ou sur un corps semi-conducteur d'un deuxième type de conductivité opposé au premier type de conductivité, et les unes des électrodes (PL) d'une pluralité de condensateurs (Cferro) de mémoire sont reliées entre elles, et
- l'autre électrode (SN) du condensateur (Cferro) de mémoire est reliée par une résistance (R) à une ligne (5) alimentée par la tension (VPLATTE) de plaque de cellule et formée par une zone très dopée du premier type de conductivité,
**caractérisé en ce que**
- la résistance (R) est réalisée par une couche de dopage sous une couche (FOX) isolante dans le corps semi-conducteur.

2. Dispositif de mémoire suivant la revendication 1,
**caractérisé en ce que** la valeur de la résistance (R) est sensiblement plus petite que la valeur de la résistance de blocage de la jonction pn entre la première zone (1) du transistor (T) de sélection et le substrat semi-conducteur.

3. Dispositif de mémoire suivant la revendication 1 ou 2,
**caractérisé en ce que** la valeur de la résistance (R) est. réglée de façon à ce que les opérations de lecture et d'écriture dans le dispositif de mémoire ne soient pratiquement pas influencées par la résistance (R).
